# EUROPEAN PATENT APPLICATION

(11) **EP 3 567 066 A1**
(43) Date of publication of application: **13.11.2019**
(21) Application number: 19169279.7
(22) Date of filing: 15.04.2019
(51) Int. Cl.: C08G 59/40, C08J 5/00, C08G 63/00, C08K 5/00, C08L 71/12

(54) **CURABLE EPOXY COMPOSITION AND CIRCIUT MATERIAL PREPREG, THERMOSET EPOXY COMPOSITION, AND ARTICLE PREPARED THEREFROM**

(30) Priority: 08.05.2018 EP 18171258
(71) Applicant: SABIC Global Technologies B.V., 4612 PX Bergen op Zoom (NL)
(72) Inventor: TARKIN-TAS, Eylem, Selkirk, NY 12158 (US); DEGONZAGUE, Carolyn A., Selkirk, NY 12158 (US); AGARWAL, Parminder, Selkirk, NY 12158 (US)
(74) Representative: Lang, Johannes

(57) **Abstract**

A curable epoxy composition includes an epoxy resin, a hydroxyl-terminated polyphenylene ether, and an oligomeric aromatic organophosphate ester flame retardant, wherein at least 60% of the oligomeric aromatic organophosphate ester flame retardant includes at least two hydroxy terminal groups, and the amount of each component of the composition is specified herein. The composition can be particularly useful in circuit material prepregs, thermoset epoxy compositions, and various articles. A method for the manufacture of a thermoset composition is also described.

## Description

### BACKGROUND

Polyarylene ethers are a class of thermoplastics known for excellent water resistance, dimensional stability, and inherent flame retardancy, as well as outstanding dielectric properties over wide frequency and temperature ranges. Properties such as ductility, stiffness, chemical resistance, and heat resistance can be tailored by reacting thermosetting polyarylene ether with various crosslinking agents in order to meet requirements of a wide variety of end uses, for example, fluid engineering parts, electrical enclosures, automotive parts, and insulation for wire and cable. In particular, polyarylene ether copolymers have been used in thermoset compositions for electronics applications, where they provide improved toughness and dielectric properties, among other benefits.

With recent trends towards miniaturization in electronic devices and requirements for processing massive information at high speed, improvements in printed circuit board materials used in these applications, such as lower dielectric constant and lower dielectric loss, better flame retardancy, and better heat resistance, have been required. In order to meet these requirements, various attempts have been made in the thermoset formulations with different compositions.

Accordingly, there remains a need in the art for improved polyphenylene ether-containing compositions that can meet the requirements of thermoset compositions for electronics applications. In particular, it would be especially advantageous to provide a composition having improved dielectric constant and dielectric loss, flame retardancy, and heat resistance.

### BRIEF DESCRIPTION

A curable epoxy composition comprises 20-93 weight percent of an epoxy resin; 2-80 weight percent of a hydroxyl-terminated polyphenylene ether; and 2-78 weight percent of an oligomeric aromatic organophosphate ester flame retardant wherein at least 60% of the oligomeric aromatic organophosphate ester flame retardant comprises at least two hydroxy terminal groups.

A circuit material prepreg comprises the curable epoxy resin composition.

A thermoset epoxy composition comprises the cured product of the curable epoxy composition or prepreg.

An article comprises the thermoset epoxy composition.

A method for the manufacture of a thermoset epoxy composition comprises curing the epoxy composition.

The above described and other features are exemplified by the following detailed description.

### DETAILED DESCRIPTION

The present inventors have unexpectedly found that a curable epoxy composition including particular amounts of various components can provide improved dielectric constant and dielectric loss, flame retardancy, and heat resistance. The composition includes an epoxy resin, a hydroxyl-terminated polyphenylene ether, and an oligomeric aromatic organophosphate ester flame retardant. The compositions disclosed herein can be particularly useful for preparing cured materials for various applications.

Accordingly, an aspect of the present disclosure is a curable epoxy composition. The curable epoxy composition comprises an epoxy resin. The epoxy resin can generally be any epoxy resin that is suitable for use in thermosetting resins. Epoxy resins useful as thermosetting resins can be produced by reaction of phenols or polyphenols with epichlorohydrin to form polyglycidyl ethers. Examples of useful phenols for production of epoxy resins include substituted bisphenol A, bisphenol F, hydroquinone, resorcinol, tris-(4-hydroxyphenyl)methane, and novolac resins derived from phenol or *o*-cresol. Epoxy resins can also be produced by reaction of aromatic amines, such as p-aminophenol or methylenedianiline, with epichlorohydrin to form polyglycidyl amines.

For example, the epoxy resin can comprise a diglycidyl-substituted epoxy resin, a triglycidyl-substituted epoxy resin, a tetraglycidyl-substituted epoxy resin, or a combination comprising at least one of the foregoing. Preferably, the epoxy resin comprises a bisphenol A epoxy resin, a bisphenol F epoxy resin, a phenol novolak epoxy resin, a cresol novolak epoxy resin, a cycloaliphatic diglycidyl ester epoxy resin, a cycloaliphatic epoxy resin comprising a ring epoxy group, an epoxy resin containing a spiro-ring, a hydantoin epoxy resin, tris-(4-hydroxyphenyl)methane epoxy resin, or a combination comprising at least one of the foregoing. In some embodiments, the epoxy resin comprises a bisphenol A epoxy resin.

The epoxy resin can be present in the composition in an amount of 20-93 weight percent (wt%), based on the total weight of the composition. Within this range, the epoxy resin can be present in an amount of 30-93 wt%, or 45-85 wt%, or 50-80 wt%, each based on the total weight of the composition.

In addition to the epoxy resin, the curable composition further comprises a hydroxyl-terminated polyphenylene ether. The hydroxyl-terminated polyphenylene ether comprises at least one phenolic end groups that can be obtained, for example, by reacting a monohydric phenol, for example having a methyl group ortho to the phenol oxygen, and a dihydric phenol in the presence of molecular oxygen and a polymerization catalyst comprising a metal ion and at least one amine ligand. Methods for this process are described, for example, in U.S. Patent No. 3,306,874 to Hay, U.S. Patent No. 4,463,164 to Dalton et al., and U.S. Patent No. 3,789,054 to Izawa et al. In an embodiment, the hydroxyl-terminated polyphenylene ether can be a product mixture of the reaction of a monohydric phenol, a dihydric phenol, a metal catalyst, and a (C₁₋₁₂ hydrocarbyl)(C₁₋₁₂ hydrocarbyl)amine.

The monohydric phenol has one hydroxy group bound directly to an aromatic ring. Exemplary monohydric phenols includes those phenol having the structure (1) 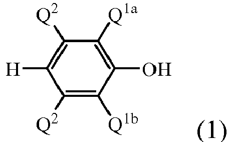 wherein Q^{1a} is a C₁₋₁₂ primary or secondary alkyl; Q^{1b} is halogen, C₁₋₁₂ hydrocarbyl provided that the hydrocarbyl group is not tertiary hydrocarbyl, C₁₋₁₂ hydrocarbylthio, C₁₋₁₂ hydrocarbyloxy, or C₂₋₁₂ halohydrocarbyloxy wherein at least two carbon atoms separate the halogen and oxygen atoms; and each occurrence of Q² is independently hydrogen, halogen, unsubstituted or substituted C₁₋₁₂ hydrocarbyl provided that the hydrocarbyl group is not tertiary hydrocarbyl, C₁₋₁₂ hydrocarbylthio, C₁₋₁₂ hydrocarbyloxy, or C₂₋₁₂ halohydrocarbyloxy wherein at least two carbon atoms separate the halogen and oxygen atoms. In some embodiments, Q^{1a} is methyl, and Q^{1b} is halogen, unsubstituted C₁₋₁₂ alkyl provided that the alkyl group is not tertiary alkyl, or unsubstituted C₁₋₁₂ aryl.

In some embodiments, the monohydric phenol is 2,6-dimethylphenol, 2-methylphenol, 2,5-dimethylphenol, 2,3,6-trimethylphenol, 2-methyl-6-phenyl phenol, or a combination comprising at least one of the foregoing. In some embodiments, the monohydric phenol is 2,6-dimethylphenol.

The dihydric phenol has two hydroxy groups bound directly to the same aromatic ring or to two different aromatic rings within the same molecule. Exemplary dihydric phenols include those having the structure (2) 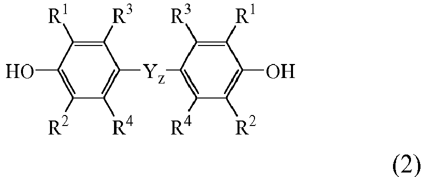 wherein each occurrence of R¹, R², R³, and R⁴ is independently hydrogen, halogen, C₁₋₁₂ hydrocarbyl provided that the hydrocarbyl group is not tertiary hydrocarbyl, C₁₋₁₂ hydrocarbylthio, C₁₋₁₂ hydrocarbyloxy, or C₂₋₁₂ halohydrocarbyloxy wherein at least two carbon atoms separate the halogen and oxygen atoms; z is 0 or 1; and Y is 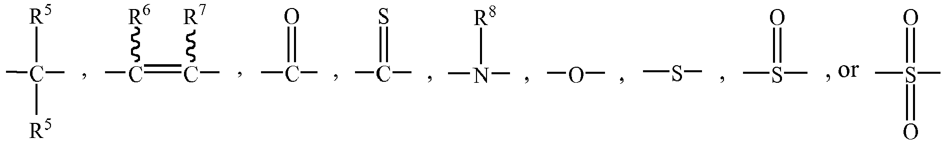 wherein each occurrence of R⁵, R⁶, R⁷, and R⁸ is independently hydrogen, C₁₋₁₂ hydrocarbyl, or C₁₋₆ hydrocarbylene wherein the two occurrences of R⁵ collectively form a C₄₋₁₂ alkylene group. When z is 0, the two aryl groups are connected by a single bond. In some embodiments, z is 1. Examples of dihydric phenols include 3,3',5,5'-tetramethyl-4,4'-biphenol, 2,2-bis(3-methyl-4-hydroxyphenyl)propane, 2,2-bis(3,5-dimethyl-4-hydroxyphenyl)propane, 1,1-bis(4-hydroxyphenyl)methane, 1, 1-bis(4-hydroxyphenyl)ethane, 2,2-bis(4-hydroxyphenyl)propane, 2,2-bis(4-hydroxyphenyl)butane, 2,2-bis(4-hydroxyphenyl)octane, 1,1-bis(4-hydroxyphenyl)propane, 1,1-bis(4-hydroxyphenyl)-*n*-butane, bis(4-hydroxyphenyl)phenylmethane, 2,2-bis(4-hydroxy-3-methylphenyl)propane, 1,1-bis(4-hydroxy-3-methylphenyl)cyclohexane, 1,1-bis(4-hydroxy-3,5-dimethylphenyl)cyclopentane, 1,1-bis(4-hydroxy-3,5-dimethylphenyl)cyclohexane, 1,1-bis(4-hydroxy-3-methylphenyl)cycloheptane, 1,1-bis(4-hydroxy-3,5-dimethylphenyl)cycloheptane, 1,1 -bis(4-hydroxy-3-methylphenyl)cyclooctane, 1,1-bis(4-hydroxy-3,5-dimethylphenyl)cyclooctane, 1,1 -bis(4-hydroxy-3-methylphenyl)cyclononane, 1,1-bis(4-hydroxy-3,5-dimethylphenyl)cyclononane, 1,1-bis(4-hydroxy-3-methylphenyl)cyclodecane, 1,1-bis(4-hydroxy-3,5-dimethylphenyl)cyclodecane, 1,1-bis(4-hydroxy-3-methylphenyl)cycloundecane, 1,1-bis(4-hydroxy-3,5-dimethylphenyl)cycloundecane, 1,1-bis(4-hydroxy-3-methylphenyl)cyclododecane, 1,1-bis(4-hydroxy-3,5-dimethylphenyl)cyclododecane, 1,1-bis(4-hydroxy-3-*t-*butylphenyl)propane, 2,2-bis(4-hydroxy-2,6-dimethylphenyl)propane, 2,2-bis(4-hydroxy-3-bromophenyl)propane, 1,1-bis(4-hydroxyphenyl)cyclopentane, 1,1-bis(4-hydroxyphenyl)cyclohexane, 2,2',6,6'-tetramethyl-3,3',5,5'-tetrabromo-4,4'-biphenol, 2,2',5,5'-tetramethyl-4,4'-biphenol, 2,2-bis(3,5-dimethyl-4-hydroxyphenol)propane, or a combination comprising at least one of the foregoing.

The hydroxyl-terminated polyphenylene ether of the present disclosure can be made by oxidatively polymerizing a monohydric phenol (e.g., 2,6-dimethyl phenol) in the presence of a catalyst and a dihydric phenol, by continuous addition of oxygen to a reaction mixture comprising the monomers, solvent, and polymerization catalyst to provide the hydroxyl-terminated polyphenylene ether. The molecular oxygen (O₂) can be provided as air or pure oxygen. The polymerization catalyst is a metal complex comprising a transition metal cation. The metal cation can include ions from Group VIB, VIIB, VIIIB, or IB of the periodic table, or a combination comprising at least one of the foregoing metals. Of these, chromium, manganese, cobalt, copper, or a combination comprising at least one of the foregoing ions can be used. In some embodiments, the metal ion is copper ion (Cu⁺ and Cu²⁺). Metal salts which can serve as sources of metal cations include cuprous chloride, cupric chloride, cuprous bromide, cupric bromide, cuprous iodide, cupric iodide, cuprous sulfate, cupric sulfate, cuprous tetraamine sulfate, cupric tetraamine sulfate, cuprous acetate, cupric acetate, cuprous propionate, cupric butyrate, cupric laurate, cuprous palmitate, cuprous benzoate, and the corresponding manganese salts and cobalt salts. Instead of use of any of the above-exemplified metal salts, it is also possible to add a metal or a metal oxide and an inorganic acid, organic acid or an aqueous solution of such an acid and form the corresponding metal salt or hydrate *in situ.* For example, cuprous oxide and hydrobromic acid can be added to generate cuprous bromide *in situ.*

The polymerization catalyst further comprises at least one amine ligand. The amine ligand can be, for example, a monoamine, an alkylene diamine, or a combination comprising at least one of the foregoing. Monoamines include dialkylmonoamines (such as di-n-butylamine, or DBA) and trialkylmonoamines (such as N,N-dimethylbutylamine, or DMBA). Diamines include alkylenediamines, such as N,N'-di-*tert*-butylethylenediamine, or DBEDA. Exemplary dialkylmonoamines include dimethylamine, di-*n*-propylamine , di-*n*-butylamine, di-*sec*-butyl amine, di-*tert*-butylamine, dipentylamine, dihexylamine, dioctylamine, didecylamine , dibenzylamine, methylethylamine, methylbutylamine, dicyclohexylamine, N-phenylethanolamine, N-(*p*-methyl)phenylethanolamine, N-(2,6-dimethyl)phenylethanolamine, N-(*p*-chloro)phenylethanolamine, N-ethylaniline, N-butyl aniline, N-methyl-2-methylaniline, N-methyl-2,6-dimethylaniline, diphenylamine, and the like, or a combination comprising at least one of the foregoing. Exemplary trialkylmonoamines include trimethylamine, triethylamine, tripropylamine, tributylamine, butyldimethylamine, phenyldiethylamine, and the like, or a combination comprising at least one of the foregoing.

Exemplary alkylenediamines include those having the formula:

(R^{b})₂N-R^{a}-N(R^{b})₂

wherein R^{a} is a substituted or unsubstituted divalent residue; and each R^{b} is independently hydrogen or C₁₋₈ alkyl. In some examples, of the above formula, two or three aliphatic carbon atoms form the closest link between the two diamine nitrogen atoms. Specific alkylenediamine ligands include those in which R^{a} is dimethylene (-CH₂CH₂-) or trimethylene (-CH₂CH₂CH₂-). R^{b} can be independently hydrogen, methyl, propyl, isopropyl, butyl, or a C₄₋₈ alpha-tertiary alkyl group. Examples of alkylenediamine ligands include N,N,N',N' tetramethylethylene diamine (TMED), N,N'-di-tert-butylethylenediamine (DBEDA), N,N,N',N'-tetramethyl-1,3-diaminopropane (TMPD), N-methyl-1,3-diaminopropane, N,N'-dimethyl-1,3-diaminopropane, N,N,N'-dimethyl-1,3-diaminopropane, N-ethyl-1,3-diaminopropane, N-methyl-1,4-diaminobutane, N,N'-trimethyl-1,4-diaminobutane, N,N,N'-trimethy1-1,4-diaminobutane, N,N,N',N'-tetramethyl-1,4-diaminobutane, N,N,N',N'-tetramethyl-1,5-diaminopentane, or a combination comprising at least one of the foregoing. In some embodiments, the amine ligand is di-n-butylamine (DBA), N,N-dimethylbutylamine (DMBA), N,N'-di-*tert*-butylethylenediamine (DBEDA), or or a combination comprising at least one of the foregoing. The catalyst can be prepared *in situ* by mixing a metal ion source (e.g., cuprous oxide and hydrobromic acid) and amine ligands. In some embodiments, the polymerization catalyst comprises copper ion, bromide ion, and *N*,*N*'-di-*tert*-butylethylenediamine.

The reaction to form the hydroxyl-terminated polyphenylene ether provides a composition comprising the hydroxyl-terminated polyphenylene ether having two phenolic end groups and a polyphenylene ether comprising a phenolic end group that is ortho-substituted with a (C₁₋₆ hydrocarbyl)(C₁₋₆ hydrocarbyl)aminomethylene group. For convenience, this composition is referred to herein as a hydroxyl-terminated polyphenylene ether composition. In an embodiment, the reaction to form the hydroxyl-terminated polyphenylene ether provides a hydroxyl-terminated polyphenylene ether composition comprising a hydroxyl-terminated polyphenylene ether of formula (3) 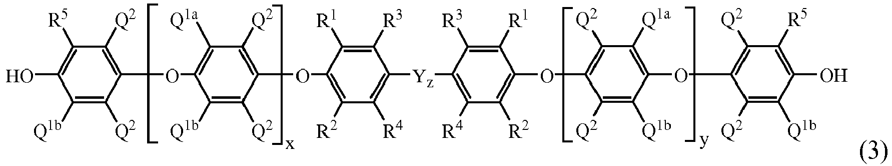 wherein Q^{1a}, Q^{1b}, Q², R¹, R², R³, R⁴, Y, and z are as described in formulas (1) and (2). Further in formula (3), each occurrence of R⁵ is independently Q^{1a} or a (C₁₋₆ hydrocarbyl)(C₁₋₆ hydrocarbyl)aminomethylene group, with the proviso that at least 50 parts per million (ppm) by weight of the R⁵ groups are (C₁₋₆ hydrocarbyl)(C₁₋₆ hydrocarbyl)aminomethylene groups, based on the total parts by weight of the copolymer. In some embodiments, at least 75 ppm, at least 100 ppm, at least 150 ppm, at least 250 ppm, at least 300 ppm, at least 400 ppm, or 50-500 ppm, 50-1,000 ppm, or 50-3,000 ppm of the of the R⁵ groups are (C₁₋₆ hydrocarbyl)(C₁₋₆ hydrocarbyl)aminomethylene groups, based on the total parts by weight of the hydroxyl-terminated polyphenylene ether. For example, the (C₁₋₆ hydrocarbyl)(C₁₋₆ hydrocarbyl)aminomethylene groups is a di(C₁₋₆ alkyl)aminomethylene group, preferably di-*n-*butylaminomethylene or 2-((tert-butyl(2-(tert-butylamino)ethyl)amino)methylene).

In formula (3), x and y represent the relative mole ratios of the arylene ether units. In an embodiment, x and y are each independently zero to 50, provided that the sum of x and y is 4-53. In some embodiments, the sum of x and y is 8-20, preferably 8-15, more preferably 8-10.

The hydroxyl-terminated polyphenylene ether (3) can comprise 80-99 wt% of repeat units derived from the monohydric phenol (1) and 1-20 wt% of repeat units derived from the dihydric phenol (2). Within this range, the hydroxyl-terminated polyphenylene ether can comprise 85-95 wt% repeat units derived from the monohydric phenol (1) and 5-15 wt% repeat units derived from the dihydric phenol (2).

In some embodiments, the monohydric phenol comprises 2,6-dimethylphenol; the dihydric phenol comprises 2,2-bis(3,5-dimethyl-4-hydroxyphenol)propane; the at least one amine ligand comprises di(*n*-butyl)amine; and a copolymer of 2,6-dimethylphenol and 2,2-bis(3,5-dimethyl-4 hydroxyphenol)propane of formula (3a) is formed: 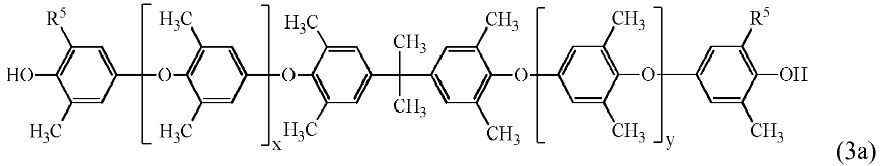 wherein each occurrence of R⁵ is independently methyl or a di-(n-butyl)aminomethylene group. In some embodiments, at least 50 parts per million (ppm) by weight of the R⁵ groups are di-(n-butyl)aminomethylene groups. In a specific embodiment, the hydroxyl-terminated polyphenylene ether is of the formula 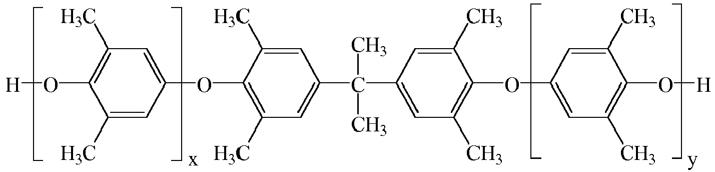 wherein x and y are independently zero to 50, provided that x + y is 4-53.

The absolute number average molecular weight of the hydroxyl-terminated polyphenylene ether can be 300-25,000 grams per mole. In some embodiments, the hydroxyl-terminated polyphenylene ether has an absolute number average molecular weight of 300-10,000 grams/mole (g/mol), or 300-8,000 g/mol, 300-5,000 g/mol, or 300-3,000 g/mol. Number average molecular weight can be determined using gel permeation chromatography relative to polystyrene standards. The hydroxyl-terminated polyphenylene ether can also have an intrinsic viscosity of 0.04-1.2 dL/g, preferably 0.055-0.095 dL/g, as measured in chloroform at 25°C by Ubbelohde viscometer.

The hydroxyl-terminated polyphenylene ether can be present in the composition in an amount of 2-80 wt%, based on the total weight of the composition. Within this range, the hydroxyl-terminated polyphenylene ether can be present in an amount of 5-40 wt%, or 10-40 wt%, or 15-35 wt%, or 15-25 wt%, each based on the total weight of the composition.

In addition to the epoxy resin and the hydroxyl-terminated polyphenylene ether, the curable composition further includes an oligomeric aromatic organophosphate ester flame retardant. At least 60% of the oligomeric aromatic organophosphate ester flame retardant comprises at least two hydroxy groups. In some embodiments, 100% of the oligomeric aromatic organophosphate ester flame retardant comprises at least two terminal hydroxy groups.

The oligomeric aromatic organophosphate ester flame retardant is an oligomer of the formula 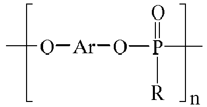 wherein Ar is a C₆₋₃₆ aromatic group, and n is 1-10, preferably wherein n is greater than 1-10. In some embodiment, Ar is an aromatic group of the formula 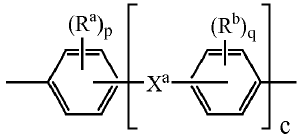 wherein R^{a} and R^{b} are each independently the same or different, and are a halogen atom or a monovalent C₁₋₆ alkyl group, p and q are each independently 0-4, c is 0-4, and X^{a} is a bridging group connecting the hydroxy-substituted aromatic groups, where the bridging group and the hydroxy substituent of each C₆ arylene group are disposed ortho, meta, or para to each other on the C₆ arylene group. In a specific embodiment, Ar is derived from resorcinol, hydroquinone, bisphenol A, bisphenol F, or 4,4'-biphenol.

The oligomeric aromatic organophosphate ester flame retardant can be present in an amount of 2-78 wt%, based on the total weight of the composition. With this range, the oligomeric aromatic organophosphate ester flame retardant can be present in an amount of 2-35 wt%, or 2-30 wt%, or 5-35 wt%, or 5-30 wt%, or 5-25 wt%, each based on the total weight of the composition.

In some embodiments, the stoichiometric ratio between the epoxy resin and the total number of hydroxyl groups present in the composition is 1.1:1-10.0:1, preferably 1.1:1-6:1, more preferably 1.1:1-2:1.

In some embodiments, the curable epoxy composition excludes any phosphorus-containing flame retardants other than the oligomeric aromatic organophosphate ester flame retardant. For example, the composition can exclude metal di(C₁₋₆ alkyl)phosphinates, melamine polyphosphates, organophosphate esters, or a combination thereof. Preferably, the curable epoxy composition of the present disclosure can comprise less than 1 wt%, or less than 0.5 wt%, or less than 0.1 wt%, or less than 0.01 wt% of any phosphorus-containing flame retardants other than the oligomeric aromatic organophosphate ester flame retardant, based on the total weight of the composition. In some embodiments, the composition is devoid of any phosphorus-containing flame retardants other than the oligomeric aromatic organophosphate ester flame retardant.

In some embodiments, the curable epoxy composition of the present disclosure can exclude a halogen-containing flame retardant. As used herein, "halogen-containing flame retardants" refer to flame retardants that do not intentionally contain halogens such as Cl or Br. It is understood, however, that in facilities that process multiple products a certain amount of cross contamination can occur resulting in halogen levels typically on the parts per million by weight scale. With this understanding it can be readily appreciated that "non-halogenated flame retardant" can be defined as having a halogen content of less than or equal to 1000 parts per million by weight (ppm), less than or equal to 500 ppm, or less than or equal to 250 ppm. When the definition "halogen-containing flame retardant" is applied to the flame retardant, it is based on the total weight of the flame retardant. When the definition halogen-containing flame retardant" is applied to the thermoplastic composition, it is based on the total weight of epoxy resin, the hydroxyl-terminated polyphenylene ether, and the flame retardant.

In some embodiments, the curable epoxy composition of the present disclosure is halogen free. As used herein, the term "halogen free" means that the compositions are essentially free of halogenated components, such as those containing the halogens chlorine or bromine, meaning that they are produced without the intentional addition of halogen-containing materials. It is understood, however, that in facilities that process multiple products a certain amount of cross contamination can occur resulting in bromine or chlorine levels typically on the parts per million by weight scale. With this understanding it can be readily appreciated that essentially free of halogen can be defined as having a bromine or chlorine content of less than or equal to 100 parts per million by weight (ppm), less than or equal to 75 ppm, or less than or equal to 50 ppm.

In addition to the epoxy resin, the hydroxyl-terminated polyphenylene ether, and the oligomeric aromatic organophosphonate flame retardant, the curable epoxy composition can optionally further comprise at least one of an auxiliary resin, a curing promoter, and an additive composition.

The auxiliary resin, when present, can comprise a second epoxy resin, a cyanate ester resin, a maleimide resin, a benzoxazine resin, a vinylbenzyl ether resin, an arylcyclobutene resin, a perfluorovinyl ether resin, oligomers or polymers with curable vinyl functionality, or a combination thereof.

The second epoxy resin can be as described above, provided that the second epoxy resin is different from the epoxy resin. Epoxy resins can be converted into solid, infusible, and insoluble three dimensional networks by curing with cross-linkers, often called curing agents, or hardeners. Curing agents are either catalytic or coreactive. Coreactive curing agents have active hydrogen atoms that can react with epoxy groups of the epoxy resin to form a cross-linked resin. The active hydrogen atoms can be present in functional groups comprising primary or secondary amines, phenols, thiols, carboxylic acids, or carboxylic acid anhydrides. Examples of coreactive curing agents for epoxy resins include aliphatic and cycloaliphatic amines and amine-functional adducts with epoxy resins, Mannich bases, aromatic amines, polyamides, amidoamines, phenalkamines, dicyandiamide, polycarboxylic acid-functional polyesters, carboxylic acid anhydrides, amine-formaldehyde resins, phenol-formaldehyde resins, polysulfides, polymercaptans, or a combination comprising at least one of the foregoing coreactive curing agents. A catalytic curing agent functions as an initiator for epoxy resin homopolymerization or as an accelerator for coreactive curing agents. Examples of catalytic curing agents include tertiary amines, such as 2-ethyl-4-methylimidazole, Lewis acids, such as boron trifluoride, and latent cationic cure catalysts, such as diaryliodonium salts.

The thermoset resin can be a cyanate ester or a phenolic resin. Cyanate esters are compounds having a cyanate group (-OC≡N) bonded to carbon via the oxygen atom. Cyanate esters useful as thermoset resins can be produced by reaction of a cyanogen halide with a phenol or substituted phenol. Examples of useful phenols include bisphenols utilized in the production of epoxy resins, such as bisphenol A, bisphenol F, and novolac resins based on phenol or *o*-resol. Cyanate ester prepolymers are prepared by polymerization/cyclotrimerization of cyanate esters. Prepolymers prepared from cyanate esters and diamines can also be used.

The thermoset resin can be a bismaleimide. Bismaleimide resins can be produced by reaction of a monomeric bismaleimide with a nucleophile such as a diamine, aminophenol, or amino benzhydrazide, or by reaction of a bismaleimide with diallyl bisphenol A. Specific examples of bismaleimide resins can include 1,2-bismaleimidoethane, 1,6-bismaleimidohexane, 1,3-bismaleimidobenzene, 1,4-bismaleimidobenzene, 2,4-bismaleimidotoluene, 4,4'-bismaleimidodiphenylmethane, 4,4'-bismaleimidodiphenylether, 3,3'-bismaleimidodiphenylsulfone, 4,4'-bismaleimidodiphenylsulfone, 4,4'-bismaleimidodicyclohexylmethane, 3,5-bis(4-maleimidophenyl)pyridine, 2,6-bismaleimidopyridine, 1,3-bis(maleimidomethyl)cyclohexane, 1,3-bis(maleimidomethyl)benzene, 1,1-bis(4-maleimidophenyl)cyclohexane, 1,3-bis(dichloromaleimido)benzene, 4,4'-bis(citraconimido)diphenylmethane, 2,2-bis(4-maleimidophenyl)propane, 1-phenyl-1,1-bis(4-maleimidophenyl)ethane, N,N-bis(4-maleimidophenyl)toluene, 3,5-bismaleimido-1,2,4-triazole N,N'-ethylenebismaleimide, N,N'-hexamethylenebismaleimide, N,N'-m-phenylenebismaleimide, N,N'-p-phenylenebismaleimide, N,N'-4,4'-diphenylmethanebismaleimide, N,N'-4,4'-diphenyletherbismaleimide, N,N'-4,4'-diphenylsufonebismaleimide, N,N'-4,4'-dicyclohexylmethanebismaleimide, N,N'-alpha,alpha'-4,4'-dimethylenecyclohexanebismaleimide, N,N'-m-methaxylenebismaleimide, N,N'-4,4'-diphenylcyclohexanebismaleimide, and N,N'-methylenebis(3-chloro-p-phenylene)bismaleimide, as well as the maleimide resins disclosed in U.S. Pat. Nos. 3,562,223 to Bargain et al., and 4,211,860 and 4,211,861 to Stenzenberger. Bismaleimide resins can be prepared by methods known in the art, as described, for example, in U.S. Pat. No. 3,018,290 to Sauters et al. In some embodiments, the bismaleimide resin is N,N'-4,4'-diphenylmethane bismaleimide.

The thermoset resin can be a benzoxazine resin. As is well known, benzoxazine monomers are made from the reaction of three reactants, aldehydes, phenols, and primary amines with or without solvent. U.S. Pat. No. 5,543,516 to Ishida describes a solventless method of forming benzoxazine monomers. An article by Ning and Ishida in Journal of Polymer Science, Chemistry Edition, vol. 32, page 1121 (1994) describes a procedure using a solvent. The procedure using solvent is generally common to the literature of benzoxazine monomers.

The preferred phenolic compounds for forming benzoxazines include phenols and polyphenols. The use of polyphenols with two or more hydroxyl groups reactive in forming benzoxazines can result in branched and/or crosslinked products. The groups connecting the phenolic groups into a phenol can be branch points or connecting groups in the polybenzoxazine.

Exemplary phenols for use in the preparation of benzoxazine monomers include phenol, cresol, resorcinol, catechol, hydroquinone, 2-allylphenol, 3-allylphenol, 4-allylphenol, 2,6-dihydroxynaphthalene, 2,7-dihydrooxynapthalene, 2-(diphenylphosphoryl)hydroquinone, 2,2'-biphenol, 4,4-biphenol, 4,4'-isopropylidenediphenol (bisphenol A), 4,4'-isopropylidenebis(2-methylphenol), 4,4'-isopropylidenebis(2-allylphenol), 4,4'(1,3-phenylenediisopropylidene)bisphenol (bisphenol M), 4,4'-isopropylidenebis(3-phenylphenol) 4,4'-(1,4-phenylenediisoproylidene)bisphenol (bisphenol P), 4,4'-ethylidenediphenol (bisphenol E), 4,4'oxydiphenol, 4,4'thiodiphenol, 4,4'-sufonyldiphenol, 4,4'-sulfinyldiphenol, 4,4'-hexafluoroisoproylidene)bisphenol (Bisphenol AF), 4,4'(1-phenylethylidene)bisphenol (Bisphenol AP), bis(4-hydroxyphenyl)-2,2-dichloroethylene (Bisphenol C), Bis(4-hydroxyphenyl)methane (Bisphenol-F), 4,4'-(cyclopentylidene)diphenol, 4,4'-(cyclohexylidene)diphenol (Bisphenol Z), 4,4'-(cyclododecylidene)diphenol 4,4'-(bicyclo[2.2.1]heptylidene)diphenol, 4,4'-(9H-fluorene-9,9-diyl)diphenol, isopropylidenebis(2-allylphenol), 3,3-bis(4-hydroxyphenyl)isobenzofuran-1(3H)-one, 1-(4-hydroxyphenyl)-3,3-dimethy1-2,3-dihydro-1H-inden-5-ol,3,3,3',3'-tetramethyl-2,2',3,3'-tetrahydro-1,1'-spirobi[indene]-5,6'-diol (Spirobiindane), dihydroxybenzophenone (bisphenol K), tris(4-hydroxyphenyl)methane, tris(4-hydroxyphenyl)ethane, tris(4-hydroxyphenyl)propane, tris(4-hydroxyphenyl)butane, tris(3-methyl-4-hydroxyphenyl)methane, tetrakis(4-hydroxyphenyl)ethane dicyclopentadienylbis(2,6-dimethyl phenol), dicyclopentadienyl bis(ortho-resol), dicyclopentadienyl bisphenol, and the like.

The aldehydes used to form the benzoxazine can be any aldehyde. In some embodiments, the aldehyde has 1-10 carbon atoms. In some embodiments, the aldehyde is formaldehyde. The amine used to form the benzoxazine can be an aromatic amine, an aliphatic amine, an alkyl substituted aromatic, or an aromatic substituted alkyl amine. The amine can also be a polyamine, although the use of polyamines will, under some circumstances, yield polyfunctional benzoxazine monomers. Polyfunctional benzoxazine monomers are more likely to result in branched and/or crosslinked polybenzoxazines than monofunctional benzoxazines, which would be anticipated to yield thermoplastic polybenzoxazines.

The amines for forming benzoxazines generally have 1-40 carbon atoms unless they include aromatic rings, and then they can have 6-40 carbon atoms. The amine of di- or polyfunctional can also serve as a branch point to connect one polybenzoxazine to another. Thermal polymerization has been the preferred method for polymerizing benzoxazine monomers. The temperature to induce thermal polymerization is typically varied from 150-300° C. The polymerization is typically done in bulk, but could be done from solution or otherwise. Catalysts, such as carboxylic acids, have been known to slightly lower the polymerization temperature or accelerate the polymerization rate at the same temperature.

The thermoset resin can be a vinylbenzyl ether resin. Vinyl benzyl ether resins can be most readily prepared from condensation of a phenol with a vinyl benzyl halide, such as vinylbenzyl chloride to produce a vinylbenzyl ether. Bisphenol A and trisphenols and polyphenols are generally used to produce poly(vinylbenzyl ethers) which can be used to produce crosslinked thermosetting resins. Vinyl benzyl ethers useful in the present composition can include those vinylbenzyl ethers produced from reaction of vinylbenzyl chloride or vinylbenzyl bromide with resorcinol, catechol, hydroquinone, 2,6-dihydroxy naphthalene, 2,7-dihydroxynapthalene, 2-(diphenylphosphoryl)hydroquinone, bis(2,6-dimethylphenol) 2,2'-biphenol, 4,4-biphenol, 2,2',6,6'-tetramethylbiphenol, 2,2',3,3',6,6'-hexamethylbiphenol, 3,3',5,5'-tetrabromo-2,2'6,6'-tetramethylbiphenol, 3,3'-dibromo-2,2',6,6'-tetramethylbiphenol, 2,2',6,6'-tetramethyl-3,3'5-dibromobiphenol, 4,4'-isopropylidenediphenol (bisphenol A), 4,4'-isopropylidenebis(2,6-dibromophenol) (tetrabromobisphenol A), 4,4'-isopropylidenebis(2,6-dimethylphenol) (teramethylbisphenol A), 4,4'-isopropylidenebis(2-methylphenol), 4,4'-isopropylidenebis(2-allylphenol), 4,4'(1,3-phenylenediisopropylidene)bisphenol (bisphenol M), 4,4'-isopropylidenebis(3-phenylphenol) 4,4'-(1,4-phenylenediisoproylidene)bisphenol (bisphenol P), 4,4'-ethylidenediphenol (bisphenol E), 4,4'-oxydiphenol, 4,4'-thiodiphenol, 4,4'-thiobis(2,6-dimethylphenol), 4,4'-sufonyldiphenol, 4,4'-sulfonylbis(2,6-dimethylphenol) 4,4'-sulfinyldiphenol, 4,4'-hexafluoroisoproylidene)bisphenol (Bisphenol AF), 4,4'(1-phenylethylidene)bisphenol (Bisphenol AP), bis(4-hydroxyphenyl)-2,2-dichloroethylene (Bisphenol C), bis(4-hydroxyphenyl)methane (Bisphenol-F), bis(2,6-dimethyl-4-hydroxyphenyl)methane, 4,4'-(cyclopentylidene)diphenol, 4,4'-(cyclohexylidene)diphenol (Bisphenol Z), 4,4'-(cyclododecylidene)diphenol 4,4'-(bicyclo[2.2.1]heptylidene)diphenol, 4,4'-(9H-fluorene-9,9-diyl)diphenol, 3,3-bis(4-hydroxyphenyl)isobenzofuran-1(3H)-one, 1-(4-hydroxyphenyl)-3,3-dimethyl-2,3-dihydro-1H-inden-5-ol, 1-(4-hydroxy-3,5-dimethylphenyl)-1,3,3,4,6-pentamethyl-2,3-dihydro-1H-inden-5-ol, 3,3,3',3'-tetramethyl-2,2',3,3'-tetrahydro-1,1'-spirobi[indene]-5,6'-diol (Spirobiindane), dihydroxybenzophenone (bisphenol K), tris(4-hydroxyphenyl)methane, tris(4-hydroxyphenyl)ethane, tris(4-hydroxyphenyl)propane, tris(4-hydroxyphenyl)butane, tris(3-methyl-4-hydroxyphenyl)methane, tris(3,5-dimethyl-4-hydroxyphenyl)methane, tetrakis(4-hydroxyphenyl)ethane, tetrakis(3,5-dimethyl-4-hydroxyphenyl)ethane, bis(4-hydroxyphenyl)phenylphosphine oxide, dicyclopentadienylbis(2,6-dimethyl phenol), dicyclopentadienyl bis(ortho-resol), dicyclopentadienyl bisphenol, and the like.

The thermoset resin can be an arylcyclobutene resin. Arylcyclobutenes include those derived from compounds of the general structure 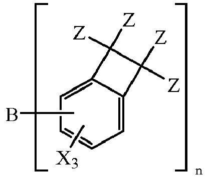 wherein B is an organic or inorganic radical of valence n (including carbonyl, sulfonyl, sulfinyl, sulfide, oxy, alkylphosphonyl, arylphosphonyl, isoalkylidene, cycloalkylidene, arylalkylidene, diarylmethylidene, methylidene dialkylsilanyl, arylalkylsilanyl, diarylsilanyl and C₆₋₂₀ phenolic compounds); each occurrence of X is independently hydroxy or C₁₋₂₄ hydrocarbyl (including linear and branched alkyl and cycloalkyl); and each occurrence of Z is independently hydrogen, halogen, or C₁₋₁₂ hydrocarbyl; and n is 1-1000, preferably 1-8, more preferably 2, 3, or 4. Other useful arylcyclobutenes and methods of arylcyclobutene synthesis can be found in U.S. Patent Nos. 4,743,399, 4,540,763, 4,642,329, 4,661,193, and 4,724,260, and 5,391,650.

The thermoset resin can be a perfluorovinyl ether resin. Perfluorovinyl ethers are typically synthesized from phenols and bromotetrafluoroethane followed by zinc catalyzed reductive elimination producing ZnFBr and the desired perfluorovinylether. By this route bis, tris, and other polyphenols can produce bis-, tris- and poly(perfluorovinylether)s. Phenols useful in their synthesis include resorcinol, catechol, hydroquinone, 2,6-dihydroxy naphthalene, 2,7-dihydroxynapthalene, 2-(diphenylphosphoryl)hydroquinone, bis(2,6-dimethylphenol) 2,2'-biphenol, 4,4-biphenol, 2,2',6,6'-tetramethylbiphenol, 2,2',3,3',6,6'-hexamethylbiphenol, 3,3',5,5'-tetrabromo-2,2'6,6'-tetramethylbiphenol, 3,3'-dibromo-2,2',6,6'-tetramethylbiphenol, 2,2',6,6'-tetramethyl-3,3'5-dibromobiphenol, 4,4'-isopropylidenediphenol (bisphenol A), 4,4'-isopropylidenebis(2,6-dibromophenol) (tetrabromobisphenol A), 4,4'-isopropylidenebis(2,6-dimethylphenol) (teramethylbisphenol A), 4,4'-isopropylidenebis(2-methylphenol), 4,4'-isopropylidenebis(2-allylphenol), 4,4'(1,3-phenylenediisopropylidene)bisphenol (bisphenol M), 4,4'-isopropylidenebis(3-phenylphenol) 4,4'-(1,4-phenylenediisoproylidene)bisphenol (bisphenol P), 4,4'-ethylidenediphenol (bisphenol E), 4,4'oxydiphenol, 4,4'thiodiphenol, 4,4'thiobis(2,6-dimethylphenol), 4,4'-sufonyldiphenol, 4,4'-sulfonylbis(2,6-dimethylphenol) 4,4'-sulfinyldiphenol, 4,4'-hexafluoroisoproylidene)bisphenol (Bisphenol AF), 4,4'(1-phenylethylidene)bisphenol (Bisphenol AP), bis(4-hydroxyphenyl)-2,2-dichloroethylene (Bisphenol C), bis(4-hydroxyphenyl)methane (Bisphenol-F), bis(2,6-dimethyl-4-hydroxyphenyl)methane, 4,4'-(cyclopentylidene)diphenol, 4,4'-(cyclohexylidene)diphenol (Bisphenol Z), 4,4'-(cyclododecylidene)diphenol 4,4'-(bicyclo[2.2.1]heptylidene)diphenol, 4,4'-(9H-fluorene-9,9-diyl)diphenol, 3,3-bis(4-hydroxyphenyl)isobenzofuran-1(3H)-one, 1-(4-hydroxyphenyl)-3,3-dimethyl-2,3-dihydro-1H-inden-5-ol, 1-(4-hydroxy-3,5-dimethylphenyl)-1,3,3,4,6-pentamethyl-2,3-dihydro-1H-inden-5-ol,3,3,3',3'-tetramethyl-2,2',3,3'-tetrahydro-1,1'-spirobi[indene]-5,6'-diol (Spirobiindane), dihydroxybenzophenone (bisphenol K), tris(4-hydroxyphenyl)methane, tris(4-hydroxyphenyl)ethane, tris(4-hydroxyphenyl)propane, tris(4-hydroxyphenyl)butane, tris(3-methyl-4-hydroxyphenyl)methane, tris(3,5-dimethyl-4-hydroxyphenyl)methane, tetrakis(4-hydroxyphenyl)ethane, tetrakis(3,5-dimethyl-4-hydroxyphenyl)ethane, bis(4-hydroxyphenyl)phenylphosphine oxide, dicyclopentadienylbis(2,6-dimethyl phenol), dicyclopentadienyl bis(2-methylphenol), dicyclopentadienyl bisphenol, and the like.

The thermoset resin can be an oligomer or polymer with curable vinyl functionality. Such materials include oligomers and polymers having crosslinkable unsaturation. Examples include styrene butadiene rubber (SBR), butadiene rubber (BR), and nitrile butadiene rubber (NBR) having unsaturated bonding based on butadiene; natural rubber (NR), isoprene rubber (IR), chloroprene rubber (CR), butyl rubber (IIR), and halogenated butyl rubber having unsaturated bonding based on isoprene; ethylene-α-olefin copolymer elastomers having unsaturated bonding based on dicyclopentadiene (DCPD), ethylidene norbornene (ENB), or 1,4-dihexadiene (1,4-HD) (namely, ethylene-α-olefin copolymers obtained by copolymerizing ethylene, an α-olefin, and a diene, such as ethylene-propylene-diene terpolymer (EPDM) and ethylene-butene-diene terpolymer (EBDM). In some embodiments, an EBDM is used. Examples also include hydrogenated nitrile rubber, fluorocarbon rubbers such as vinylidenefluoride-hexafluoropropene copolymer and vinylidenefluoride-pentafluoropropene copolymer, epichlorohydrin homopolymer (CO), copolymer rubber (ECO) prepared from epichlorohydrin and ethylene oxide, epichlorohydrin allyl glycidyl copolymer, propylene oxide allyl glycidyl ether copolymer, propylene oxide epichlorohydrin allyl glycidyl ether terpolymer, acrylic rubber (ACM), urethane rubber (U), silicone rubber (Q), chlorosulfonated polyethylene rubber (CSM), polysulfide rubber (T) and ethylene acrylic rubber. Further examples include various liquid rubbers, for example various types of liquid butadiene rubbers, and the liquid atactic butadiene rubber that is butadiene polymer with 1,2-vinyl connection prepared by anionic living polymerization. It is also possible to use liquid styrene butadiene rubber, liquid nitrile butadiene rubber (CTBN, VTBN, ATBN, etc. by Ube Industries, Ltd.), liquid chloroprene rubber, liquid polyisoprene, dicyclopentadiene type hydrocarbon polymer, and polynorbornene (for example, as sold by Elf Atochem).

Polybutadiene resins, generally polybutadienes containing high levels of 1,2 addition are desirable for thermosetting matrices. Examples include the functionalized polybutadienes and poly(butadiene-styrene) random copolymers sold by Ricon Resins, Inc. under the trade names RICON, RICACRYL, and RICOBOND resins. These include butadienes containing both low vinyl content such as RICON 130, 131, 134, 142; polybutadienes containing high vinyl content such as RICON 150, 152, 153, 154, 156, 157, and P30D; random copolymers of styrene and butadiene including RICON 100, 181, 184, and maleic anhydride grafted polybutadienes and the alcohol condensates derived therefrom such as RICON 130MA8, RICON MA13, RICON 130MA20, RICON 131MAS, RICON 131MA10, RICON MA17, RICON MA20, RICON 184MA6 and RICON 156MA17. Also included are polybutadienes that can be used to improve adhesion including RICOBOND 1031, RICOBOND 1731, RICOBOND 2031, RICACRYL 3500, RICOBOND 1756, RICACRYL 3500; the polybutadienes RICON 104 (25% polybutadiene in heptane), RICON 257 (35% polybutadiene in styrene), and RICON 257 (35% polybutadiene in styrene); (meth)acrylic functionalized polybutadienes such as polybutadiene diacrylates and polybutadiene dimethacrylates. These materials are sold under the tradenames RICACRYL 3100, RICACRYL 3500, and RICACRYL 3801. Also are included are powder dispersions of functional polybutadiene derivatives including, for example, RICON 150D, 152D, 153D, 154D, P30D, RICOBOND 0 1731 HS, and RICOBOND 1756HS. Further butadiene resins include poly(butadiene-isoprene) block and random copolymers, such as those with molecular weights from 3,000-50,000 grams per mole and polybutadiene homopolymers having molecular weights from 3,000-50,000 grams per mole. Also included are polybutadiene, polyisoprene, and polybutadiene-isoprene copolymers functionalized with maleic anhydride functions, 2-hydroxyethylmaleic functions, or hydroxylated functionality.

Further examples of oligomers and polymers with curable vinyl functionality include unsaturated polyester resins based on maleic anhydride, fumaric acid, itaconic acid and citraconic acid; unsaturated epoxy (meth)acrylate resins containing acryloyl groups, or methacryloyl group; unsaturated epoxy resins containing vinyl or allyl groups, urethane (meth)acrylate resin, polyether (meth)acrylate resin, polyalcohol (meth)acrylate resins, alkyd acrylate resin, polyester acrylate resin, spiroacetal acrylate resin, diallyl phthalate resin, diallyl tetrabromophthalate resin, diethyleneglycol bisallylcarbonate resin, and polyethylene polythiol resins.

Crosslinking agents can be added, such as compounds containing alkene or alkyne functionality. These include, maleimides such as N,N'-m-phenylene bismaleimide, triallylisocyanurate, trimethallylisocyanurate, trimethallylcyanurate, and triallylcyanurate.

Combinations of any one or more of the foregoing thermoset resins can be used as the auxiliary resin when present in the curable composition.

The term "curing promoter" as used herein encompasses compounds whose roles in curing epoxy resins are variously described as those of a hardener, a hardening accelerator, a curing catalyst, and a curing co-catalyst, among others. Hardeners are coreactive curing agents. Hardeners react with the epoxy groups and/or the secondary hydroxyl groups of the epoxy resin. Exemplary hardeners for epoxy resins are known in the art and include, for example, amines, dicyandiamide, polyamides, amidoamines, Mannich bases, anhydrides, phenalkamines, carboxylic acid anhydrides, amine-formaldehyde resins, phenol-formaldehyde resins, carboxylic acid functional polyesters, polysulfides, polymercaptans, isocyanates, cyanate esters, and combinations thereof.

In some embodiments, the curing promoter comprises an amine. The amine can be a polyamine, a tertiary amine, an amidine, and combinations thereof. Examples of polyamines include amine hardeners such as isophoronediamine, triethylenetetraamine, diethylenetriamine, aminoethylpiperazine, 1,2- and 1,3-diaminopropane, 2,2-dimethylpropylenediamine, 1,4-diaminobutane, 1,6-diaminohexane, 1,7-diaminoheptane, 1,8-diaminooctane, 1,9-diaminononane, 1,12-diaminododecane, 4-azaheptamethylenediamine, N,N'-bis(3-aminopropyl)butane-1,4-diamine, cyclohexanediamine, 4,4'-methylenedianiline, diethyltoluenediamine, *m*-phenylenediamine, *p*-phenylenediamine, tetraethylenepentamine, 3-diethylaminopropylamine, 3,3'-iminobispropylamine, 2,4-bis(*p*-aminobenzyl)aniline, tetraethylenepentamine, 3-diethylaminopropylamine, 2,2,4- and 2,4,4-trimethylhexamethylenediamine, 1,2- and 1,3-diaminocyclohexane, 1,4-diamino-3,6-diethylcyclohexane, 1,2-diamino-4-ethylcyclohexane, 1,4-diamino-3,6-diethylcyclohexane, 1-cyclohexyl-3,4-diaminocyclohexane, 4,4'-diaminondicyclohexylmethane, 4,4'-diaminodicyclohexylpropane, 2,2-bis(4-aminocyclohexyl)propane, 3,3'-dimethyl-4,4'-diaminodicyclohexylmethane, 3-amino-1-cyclohexaneaminopropane, 1,3- and 1,4-bis(aminomethyl)cyclohexane, *m*- and *p*-xylylenediamine, diethyl toluene diamines, and combinations thereof. In some embodiments, the curing promoter comprises a hardener selected from the group consisting of *m*-phenylenediamine, 4,4'-diaminodiphenylmethane, and combinations thereof.

Examples of amine compounds further include tertiary amine hardening accelerators such as triethylamine, tributylamine, dimethylaniline, diethylaniline, benzyldimethylamine (BDMA) α-methylbenzyldimethylamine, N,N-dimethylaminoethanol, N,N-dimethylaminocresol, tri(N,N-dimethylaminomethyl)phenol, and combinations thereof. Examples of amine compounds further include imidazole hardening accelerators such as 2-methylimidazole, 2-ethylimidazole, 2-laurylimidazole, 2-heptadecylimidazole, 2-phenylimidazole, 4-methylimidazole, 4-ethylimidazole, 4-laurylimidazole, 4-heptadecylimidazole, 2-phenyl-4-methylimidazole, 2-phenyl-4-hydroxymethylimidazole, 2-ethyl-4-methylimidazole, 2-ethyl-4-hydroxymethylimidazole, 1-cyanoethyl-4-methylimidazole, 2-phenyl-4,5-dihydroxymethylimidazole, and combinations thereof. Examples of amine compounds further include cyclic amidine hardening accelerators such as 4-diazabicyclo(2,2,2)octane (DABCO), diazabicycloundecene (DBU), 2-phenyl imidazoline, and combinations thereof.

The curing promoter can comprise other amine compounds. Examples of other amine compounds include hardeners such as ketimines, which are the reaction products of ketones and primary aliphatic amines; polyetheramines, which are the reaction products of polyols derived from ethylene oxide or propylene oxide with amines; amine-terminated polyamides, prepared by the reaction of dimerized and trimerized vegetable oil fatty acids with polyamines; amidoamines, imidazolines, and combinations thereof, for example the reaction product of diethylene triamine and tall-oil fatty acid.

The curing promoter can comprise an anhydride hardener. Examples of anhydrides include maleic anhydride (MA), phthalic anhydride (PA), hexahydro-o-phthalic anhydride (HEPA), tetrahydrophthalic anhydride (THPA), methyltetrahydrophthalic anhydride (MTHPA), methylhexahydrophthalic anhydride (MHHPA), nadic methyl anhydride (methyl himic anhydride, MHA), benzophenonetetracarboxylic dianhydride (BTDA), tetrachlorophthalic anhydride (TCPA), pyromellitic dianhydride (PMDA), trimellitic anhydride (TMA), and combinations thereof.

The curing promoter can comprise a phenol-formaldehyde resin. Exemplary phenol-formaldehyde resins include, for example, novolac type phenol resins, resole type phenol resins, aralkyl type phenol resins, dicyclopentadiene type phenol resins, terpene modified phenol resins, biphenyl type phenol resins, bisphenol type phenol resins, triphenylmethane type phenol resins, and combinations thereof.

The curing promoter can comprise a Mannich base. Examples of Mannich bases are the reaction products of an amine with phenol and formaldehyde, melamine-formaldehyde resins, urea-formaldehyde resins, and combinations thereof.

In addition to the tertiary amines listed above, the curing promoter can comprise other hardening accelerators. Exemplary examples of other hardening accelerators are substituted ureas, for example 3-phenyl-1,1-dimethyl urea; the reaction product of phenyl isocyanate with dimethylamine; the reaction product of toluene diisocyanate with dimethylamine; quaternary phosphonium salts, such as tetra(C₁₋₁₂ alkyl) and (C₁₋₁₂ alkyl)triphenyl phosphonium halide; and combinations thereof.

The curing promoter can comprise a metal salt, for example a copper (II) or aluminum (III) salt of an aliphatic or aromatic carboxylic acid. Examples of such salts include the copper (II), tin (II), and aluminum (III) salts of acetate, stearate, gluconate, citrate, benzoate, and like anions, as well as combinations thereof. The curing promoter can comprise a copper (II) or aluminum (III) β-diketonate. Examples of such metal diketonates include the copper (II) and aluminum (III) salts of acetylacetonate. The curing promoter can comprise a boron trifluoride-trialkylamine complex. An illustrative boron trifluoride-trialkylamine complex is boron trifluoride-trimethylamine complex.

The curing promoter can comprise a latent cationic cure catalyst. Latent cationic cure catalysts are used, for example, in UV-cured epoxy resin compositions. Latent cationic cure catalysts include, for example, diaryliodonium salts, phosphonic acid esters, sulfonic acid esters, carboxylic acid esters, phosphonic ylides, triarylsulfonium salts, benzylsulfonium salts, aryldiazonium salts, benzylpyridinium salts, benzylammonium salts, isoxazolium salts, and combinations thereof. For example, the curing promoter can be a latent cationic cure catalyst comprising a diaryliodonium salt having the structure [(R¹⁰)(R¹¹)I]⁺ X⁻ wherein R¹⁰ and R¹¹ are each independently a C₆₋₁₄ monovalent aromatic hydrocarbon radical, optionally substituted with from 1-4 monovalent radicals selected from C₁₋₂₀ alkyl, C₁₋₂₀ alkoxy, nitro, and chloro; and wherein X⁻ is an anion. In some embodiments, the curing promoter is a latent cationic cure catalyst comprising a diaryliodonium salt having the structure [(R¹⁰)(R¹¹)I]⁺ SbF₆⁻ wherein R¹⁰ and R¹¹ are each independently a C₆₋₁₄ monovalent aromatic hydrocarbon radical, optionally substituted with from 1-4 monovalent radicals selected from C₁₋₂₀ alkyl, C₁₋₂₀ alkoxy, nitro, and chloro. In some embodiments, the curing promoter is a latent cationic cure catalyst comprising 4-octyloxyphenyl phenyl iodonium hexafluoroantimonate.

The amount of curing promoter will depend on the type of curing promoter, as well as the identities and amounts of the other components of the curable composition. For example, when the curing promoter is a latent cationic cure catalyst, it can be used in an amount of 0.1-10 parts by weight (pbw) per 100 parts by weight total of the poly(arylene ether) and the auxiliary epoxy resin (if present). As another example, when the curing promoter is a copper (II) or aluminum (III) beta-diketonate, it can be used in an amount of 1-10 pbw per 100 parts by weight of the poly(arylene ether) and the auxiliary epoxy resin (if present). As yet another example, when the curing promoter is an amine hardener, it can be used in an amount of 2-40 pbw, per 100 parts by weight of the poly(arylene ether) and the auxiliary epoxy resin (if present). As yet another example, when the curing promoter is an imidazole hardening accelerator, it can be used in an amount of 0.01-5 pbw, per 100 parts by weight of the poly(arylene ether) and the auxiliary epoxy resin (if present).

In some embodiments, the curing promoter comprises a hardener, and the curable composition comprises the curing promoter in an amount of 0.1-50 wt%, or 0.5-30 wt%, or 1-20 wt%, preferably, 2-10 wt%, based on the weight of the curable composition.

When the curing promoter comprises a hardener, its amount can be specified in terms of equivalents relative to total epoxy equivalents. For example, when the curing promoter comprises an amine hardener, the poly(arylene ether), the curing promoter, and auxiliary epoxy resin provide a ratio of total epoxy equivalents to total amine equivalents of 1:1-1.3:1, or 1.1:1-1.2:1, or 1.1:1-1.2:1.

The additive composition can comprise a particulate filler, a fibrous filler, an antioxidant, a heat stabilizer, a light stabilizer, a ultraviolet light stabilizer, a ultraviolet light-absorbing compound, a near infrared light-absorbing compound, an infrared light-absorbing compound, a plasticizer, a lubricant, a release agent, a antistatic agent, an anti-fog agent, an antimicrobial agent, a colorant, a surface effect additive, a radiation stabilizer, an anti-drip agent, a fragrance, a polymer different from the epoxy resin, or a combination comprising at least one of the foregoing. In some embodiments, the additive composition preferably comprises a particulate filler, a fibrous filler, or a combination comprising at least one of the foregoing.

The inorganic fillers include, for example, alumina, silica (including fused silica and crystalline silica), boron nitride (including spherical boron nitride), aluminum nitride, silicon nitride, magnesia, magnesium silicate, glass fibers, glass mat, and combinations thereof. Exemplary glass fibers include those based on E, A, C, ECR, R, S, D, and NE glasses, as well as quartz. The glass fiber can have a diameter of 2-30 micrometers (µm), or 5-25 µm, or 5-15 µm. The length of the glass fibers before compounding can be 2-7 millimeters (mm), or 1.5-5 mm. Alternatively, longer glass fibers or continuous glass fibers can be used. The glass fiber can, optionally, include an adhesion promoter to improve its compatibility with the poly(arylene ether), the auxiliary epoxy resin, or both. Adhesion promoters include chromium complexes, silanes, titanates, zircon-aluminates, propylene maleic anhydride copolymers, reactive cellulose esters, and the like. Exemplary glass fiber is commercially available from suppliers including, for example, Owens Corning, Nippon Electric Glass, PPG, and Johns Manville.

When an inorganic filler is utilized, the curable composition can comprise 2-900 pbw of inorganic filler, based on 100 parts by weight total of the poly(arylene ether), the curing promoter, and the auxiliary epoxy resin. In some embodiments, the curable composition comprises 100-900 pbw inorganic filler, or 200-800 pbw inorganic filler, or 300-700 pbw inorganic filler, based on 100 parts by weight total poly(arylene ether), curing promoter, and auxiliary epoxy resin. In some embodiments, the curable composition comprises less than 50 pbw inorganic filler, or less than 30 pbw inorganic filler, or less than 10 pbw inorganic filler, based of 100 parts by weight total of the poly(arylene ether), the curing promoter, and the auxiliary epoxy resin. In some embodiments, the curable composition can be substantially free of inorganic filler (that is, the composition can comprises less than 0.1 wt% of added inorganic filler, based on 100 parts by weight of the poly(arylene ether), the curing promoter, and the auxiliary epoxy resin).

In addition to the poly(arylene ether), the curing promoter, and the auxiliary epoxy resin, the curable composition can, optionally, comprise a solvent. The solvent can have an atmospheric boiling point of 50-250°C. A boiling point in this range facilitates removal of solvent from the curable composition while minimizing or eliminating the effects of bubbling during solvent removal. The solvent promotes formation of a homogeneous resin mixture, which in turn provides wet-out and adhesion to the glass reinforcement of the prepreg. When solvent is present, the presence of the poly (arylene ether) increases the viscosity of the curable composition, reducing the flow of the curable composition at elevated temperatures, which is desirable for a lamination process.

The solvent can be, for example, a C₃₋₈ ketone, a C₃₋₈ *N,N*-dialkylamide, a C₄₋₁₆ dialkyl ether, a C₆₋₁₂ aromatic hydrocarbon, a C₁₋₃ chlorinated hydrocarbon, a C₃₋₆ alkyl alkanoate, a C₂₋₆ alkyl cyanide, or a combination thereof. The carbon number ranges refer to the total number of carbon atoms in the solvent molecule. For example, a C₄₋₁₆ dialkyl ether has 4-16 total carbon atoms, and the two alkyl groups can be the same or different. As other examples, the 3-8 carbon atoms in the "*N,N*-dialkylamide" include the carbon atom in the amide group, and the 2-6 carbons in the "C₂₋₆ alkyl cyanides" include the carbon atom in the cyanide group. Specific ketone solvents include, for example, acetone, methyl ethyl ketone, methyl isobutyl ketone, and combinations thereof. Specific C₄₋₈ *N,N*-dialkylamide solvents include, for example, dimethylformamide, dimethylacetamide, *N*-methyl-2-pyrrolidone (Chemical Abstracts Service Registry No. 872-50-4), and combinations thereof. Specific dialkyl ether solvents include, for example, tetrahydrofuran, ethylene glycol monomethylether, dioxane, and combinations thereof. In some embodiments, the C₄₋₁₆ dialkyl ethers include cyclic ethers such as tetrahydrofuran and dioxane. In some embodiments, the C₄₋₁₆ dialkyl ethers are noncyclic. The dialkyl ether can, optionally, further include one or more ether oxygen atoms within the alkyl groups and one or more hydroxy group substituents on the alkyl groups. The aromatic hydrocarbon solvent can comprise an ethylenically unsaturated solvent. Specific aromatic hydrocarbon solvents include, for example, benzene, toluene, xylenes, styrene, divinylbenzenes, and combinations thereof. The aromatic hydrocarbon solvent is preferably non-halogenated. That is, it does not include any fluorine, chlorine, bromine, or iodine atoms. Specific C₃₋₆ alkyl alkanoates include, for example, methyl acetate, ethyl acetate, methyl propionate, ethyl propionate, and combinations thereof. Specific C₂₋₆ alkyl cyanides include, for example, acetonitrile, propionitrile, butyronitrile, and combinations thereof. In some embodiments, the solvent is acetone. In some embodiments, the solvent is methyl ethyl ketone. In some embodiments, the solvent is methyl isobutyl ketone. In some embodiments, the solvent is *N*-methyl-2-pyrrolidone. In some embodiments, the solvent is dimethylformamide. In some embodiments, the solvent is ethylene glycol monomethyl ether.

When a solvent is utilized, the curable composition can comprise 2-100 pbw of the solvent, based on 100 parts by weight total of the poly(arylene ether), the curing promoter, and the auxiliary epoxy resin. Preferably, the solvent amount can be 5-80 pbw, or 10-60 pbw, or 20-40 pbw, based on 100 parts by weight total of the poly(arylene ether), the curing promoter, and the auxiliary epoxy resin. The solvent can be chosen, in part, to adjust the viscosity of the curable composition. Thus, the solvent amount can depend on variables including the type and amount of poly(arylene ether), the type and amount of curing promoter, the type and amount of auxiliary epoxy resin, and the processing temperature used for impregnation of the reinforcing structure with the curable composition.

The curable composition described herein can also be particularly well suited for use in forming various articles. For example, useful articles can be in the form of a composite, a foam, a fiber, a layer, a coating, an encapsulant, an adhesive, a sealant, a molded component, a prepreg, a casing, a laminate, a metal clad laminate, an electronic composite, a structural composite, or a combination comprising at least one of the foregoing. In some embodiments, the article can be in the form of a composite that can be used in a variety of application, for example printed circuit boards.

A method of forming a composite comprises impregnating a reinforcing structure with the curable composition described herein; partially curing and removing at least a portion of the non-halogenated solvent from the curable composition to form a prepreg; and laminating and curing a plurality of the prepregs.

Reinforcing structures suitable for prepreg formation are known in the art. Exemplary reinforcing structures include reinforcing fabrics. Reinforcing fabrics include those having complex architectures, including two- or three-dimensional braided, knitted, woven, and filament wound. The curable composition is capable of permeating these reinforcing structures. The reinforcing structure can comprise fibers of materials known for the reinforcement of plastics, for example fibers of carbon, glass, metal, and aromatic polyamides. Exemplary reinforcing structures are described, for example, in Anonymous (Hexcel Corporation), "Prepreg Technology", March 2005, Publication No. FGU 017b; Anonymous (Hexcel Corporation), "Advanced Fibre Reinforced Matrix Products for Direct Processes," June 2005, Publication No. ITA 272; and Bob Griffiths, "Farnborough Airshow Report 2006," CompositesWorld.com, September 2006. The weight and thickness of the reinforcing structure are chosen according to the intended use of the composite using criteria well known to those skilled in the production of fiber reinforced resin composites. The reinforced structure can contain various finishes compatible with the thermoset resin.

The method of forming the composite comprises partially curing the curable composition, also known as a varnish, after the reinforcing structure has been impregnated with it. Partial curing is curing sufficient to reduce or eliminate the wetness and tackiness of the curable composition yet insufficient to fully cure the composition. The thermoset resin in a prepreg is customarily partially cured. References herein to a "cured composition" refer to a composition that is fully cured. The thermoset resin in a laminate formed from prepregs is fully cured. The skilled person can readily determine whether a composition is partially cured or fully cured without undue experimentation. For example, one can analyze a sample by differential scanning calorimetry to look for an exotherm indicative of additional curing occurring during the analysis. A sample that is partially cured will exhibit an exotherm. A sample that is fully cured will exhibit little or no exotherm. Partial curing can be effected by subjecting an reinforcing structure impregnated with thermoset resin to a temperature of 133-140°C for 4-10 minutes.

The curable compositions described herein are readily adaptable to existing commercial-scale processes and equipment. For example, prepregs are often produced on treaters. The main components of a treater include feeder rollers, a resin impregnation tank, a treater oven, and receiver rollers. The reinforcing structure (E-glass, for example) is usually rolled into a large spool. The spool is then put on the feeder rollers that turn and slowly roll out the reinforcing structure. The reinforcing structure then moves through the resin impregnation tank, which contains the curable composition (varnish). The varnish impregnates the reinforcing structure. After emerging from the tank, the coated reinforcing structure moves upward through a vertical treater oven, which is at a temperature of 175-200 °C, and the solvent of the varnish is boiled away. The thermoset resin begins to polymerize at this time. When the composite comes out of the tower it is sufficiently cured so that the resulting web is not wet or tacky. However curing is stopped short of completion so that additional curing can occur when the laminate is made. The web then rolls the prepreg onto a receiver roll. Thus in some embodiments, a composite is formed by impregnating a reinforcing structure with the curable composition described herein; removing at least a portion of the non-halogenated solvent from the curable composition and effecting partial cure to form a prepreg; and laminating and curing a plurality of prepregs. The composites described herein can be used for the manufacture of printed circuit boards. Thus, a printed circuit board comprises a composite formed by impregnating a reinforcing structure with the curable composition described herein; removing at least a portion of the non-halogenated solvent from the curable composition and effecting partial cure to form a prepreg; and laminating and curing a plurality of the prepregs.

A cured, thermoset epoxy composition comprising the cured product of the curable epoxy composition or prepreg described above can be obtained by heating the curable composition defined herein for a time and temperature sufficient to evaporate the solvent and effect curing. For example, the curable composition can be heated to a temperature of 50-250°C to cure the composition and provide the thermoset composition. The cured composition can also be referred to as a thermoset composition. In curing, a cross-linked, three-dimensional polymer network is formed. In some embodiments, curing the composition can include injecting the curable composition into a mold, and curing the injected composition at 150-250°C in the mold.

The thermoset composition can have one or more desirable properties. For example, the thermoset composition can have a glass transition temperature of greater than or equal to 180°C, preferably greater than or equal to 190°C, more preferably greater than or equal to 200°C.

The thermoset composition can also advantageously exhibit a low dielectric constant (Dk). In some embodiments, the cured composition can exhibit a dielectric constant of 2.6-3.2, or 2.7-3.1, and preferably 2.8-3.1. In some embodiments, the cured composition can exhibit a dielectric loss of less than 0.0200, preferably 0.011-0.020, more preferably 0.012-0.019, and most preferably 0.015-0.019. Dielectric measurements were conducted using a capacitance method, sweeping a range of frequencies when DC voltage was applied to the dielectric materials. The applied voltage was 0.2 millivolt to 1 volt at the frequency range of 1 megahertz to 1 gigahertz. Values for dielectric constants (Dk, relative permittivity) and loss tangent (Df, dissipation factor) at a frequency of 1 gigahertz were recorded.

The thermoset epoxy composition can also have a char value of greater than 15 measured using a microscale combustion calorimeter.

The thermoset epoxy composition can also exhibit a peak heat release rate of less than 500 Watts per gram measured using a microscale combustion calorimeter.

The curable composition described herein can also be particularly well suited for use in forming various articles. For example, useful articles can be in the form of a composite, a foam, a fiber, a layer, a coating, an encapsulant, an adhesive, a sealant, a molded component, a prepreg, a casing, a laminate, a metal clad laminate, an electronic composite, a structural composite, or a combination comprising at least one of the foregoing. In some embodiments, the article can be in the form of a composite that can be used in a variety of application, for example printed circuit boards (e.g., a dielectric material for a circuit component), as described above.

This disclosure is further illustrated by the following examples, which are nonlimiting.

### EXAMPLES

Components used to form the compositions are summarized in Table 1.

**Table 1**

| Component | Description |
|---|---|
| Epoxy | Bisphenol A diglycidyl ether, CAS Reg. No. 1675-54-3, having an epoxy equivalent weight of 171-175 g/eq; obtained as D.E.R 332 from DOW Chemical Company. |
| PPE-OH | Copolymer of 2,6-dimethylphenol and 2,2-bis(3,5-dimethyl-4-hydroxyphenol)propane comprising a phenolic end group ortho-substituted with a di-*n*-butylaminomethylene group; obtained as NORYL SA90 resin from SABIC |
| Al(OP(O)Et₂)₃ | Aluminum tris(diethylphosphinate), CAS Reg. No. 225789-38-8; obtained as EXOLIT OP1230 from Clariant. |
| MPP | Melamine polyphosphate, CAS Reg. No. 218768-84-4; obtained as MELAPUR 200 from BASF. |
| BPAPn | Oligomer derived from bisphenol A and diphenyl methyl phosphonate, having a hydroxyl number of 75 and a hydroxyl equivalent weight of 748 and containing 8.5 wt% phosphorus; obtained as NOFIA OL1001 from FRX Polymers |
| 2,4-EMI | 2-ethyl-4-methyl imidazole obtained from Alfa Aeser |

Compositions were formed by dissolving all the components in the epoxy resin, degassing the resultant mixture, then pouring the degassed mixture into stainless steel molds and curing in the oven. The curing cycle was 2 hours at 120°C, 1 hour at 175°C and 2 hours at 200°C. After that, the oven was turned off and allowed to cool overnight.

Glass transition temperature (Tg) was measured by differential scanning calorimetry (DSC) using a TA Instruments differential scanning calorimeter, at a heating rate from 30°C to 200°C at a 10°C/min temperature ramp. The analyses were conducted under nitrogen. All sample weights were in the range of 15.0 ± 5 milligrams.

Dielectric measurements (dielectric constant (Dk) and dielectric loss (Df)) were made using an Agilent Network Analyzer E8363B with QWED SPDRs. Analysis of molded samples comprising the compositions was conducted at 1.1 GHz, 1.9 GHz, 5 GHz, 10 GHz, and 20 GHz.

Flame retardant properties were determined by microscale combustion calorimetry (MCC). "Char" is a measurement of residual weight percent at 900 °C, where higher char indicates potentially better flame retardance. Lower peak heat release rate (PHRR) indicates potentially better heat resistance. The MCC measurements were made using a standard MCC instrument manufactured by Deatak (formerly Govmark Ltd, McHenry, IL, USA) was used. The output of oxygen and nitrogen gases was maintained at a pressure of 15-20 psi. The supply of O₂/N₂ was controlled at 20/80 cc/min such that the total follow would be 100 cc/min and the O₂ concentration was 20%. The heating rate was 1°C/second, and the temperature of the combustor chamber was 900°C.

### Comparative Examples 1-5 and Examples 1-2

The compositions of these examples are shown in Table 2, where component amounts are expressed in weight percent, based on the total weight of the components except where indicated. Comparative examples (CEx.) 1-3 and Example (Ex.) 1 have the same content of flame retardant, and CEx. 4-5 and Ex. 2 have the same content of phosphorus.

**Table 2**

| | Units | CEx. 1 | CEx. 2 | CEx. 3 | Ex. 1 | CEx. 4 | CEx. 5 | Ex. 2 |
|---|---|---|---|---|---|---|---|---|
| Epoxy | wt% | 100 | 90 | 90 | 80 | 92 | 82 | 62 |
| PPE-OH | wt% | | | | 20 | | | 20 |
| Al(OP(O)Et₂)₃ | wt% | | 5 | | | 4 | | |
| MPP | wt% | | 5 | | | 4 | | |
| BPAPn | wt% | | | 10 | 10 | | 18 | 18 |
| 2,4-EMI | phr* | 2 | 2 | 2 | 2 | 2 | 2 | 2 |
| | | | | | | | | |
| P content | wt% | 0 | 1.64 | 0.77 | 0.77 | 1.5 | 1.5 | 1.5 |
| | | | | | | | | |
| Tg (DSC) | °C | 105 | 117 | 119 | 126 | 114 | 129 | 138 |
| Char (MCC) | wt% | 9 | 19 | 18 | 19 | 20 | 20 | 22 |
| PHRR (MCC) | W/g | 714 | 372 | 498 | 493 | 550 | 523 | 439 |
| | | | | | | | | |
| Dk (1.1 GHz) | | 3.1500 | 3.0833 | 3.0167 | 2.9067 | 3.16 | 3.01 | 2.97 |
| Df (1.1 GHz) | | 0.0280 | 0.0289 | 0.0234 | 0.0177 | 0.0229 | 0.0213 | 0.0182 |

| | | | | | | | | |
|---|---|---|---|---|---|---|---|---|
| *parts per hundred parts by weight of the epoxy and PPE-OH | | | | | | | | |

As can be seen from the data in Table 2, use of a combination of the hydroxyl-terminated PPE and the oligomeric phosphonate provides compositions having excellent flame resistance and dielectric properties, without the disadvantages of prior phosphorus-containing flame retardants. As expected, compared to the epoxy alone (CEx. 1), addition of two known phosphorus-containing flame retardants (a metal phosphinate and a melamine polyphosphate) (CEx. 2) or PPE-OH alone (CEx. 3) resulted in a higher Tg, higher char, lower PHRR, and good dielectric properties. Similar results are observed in Ex. 1, where there is expected to be no migration of the phosphonate oligomer. Ex. 1 further has significantly improved dielectric loss compared to CEx. 1-3.

The effects are more pronounced where the compositions are adjusted to contain the same amount of phosphorus. Thus, compared to the epoxy alone (CEx. 1), addition of two known phosphorus-containing flame retardants (a metal phosphinate and a melamine polyphosphate) (CEx. 4) or PPE-OH alone (CEx. 5) again resulted in a higher Tg, higher char, lower PHRR, and good dielectric properties. Addition of an amount of oligomeric phosphonate calculated to provide the same level of phosphorous, together with of PPE-OH (Ex.2), however, resulted in the best Tg, flame resistance, and dielectric properties, Dielectric loss is significantly improved.

This disclosure further encompasses the following aspects.
Aspect 1: A curable epoxy composition, comprising: 20-93 weight percent of an epoxy resin; 2-80 weight percent of a hydroxyl-terminated polyphenylene ether; and 2-78 weight percent of an oligomeric aromatic organophosphate ester flame retardant wherein at least 60% of the oligomeric aromatic organophosphate ester flame retardant comprises at least two hydroxy terminal groups.
Aspect 2: The curable epoxy composition according to aspect 1, wherein the epoxy resin composition comprises a diglycidyl-substituted epoxy resin, a triglycidyl-substituted epoxy resin, a tetraglycidyl-substituted epoxy resin, preferably a bisphenol A epoxy resin, a bisphenol F epoxy resin, a phenol novolak epoxy resin, a cresol novolak epoxy resin, a cycloaliphatic diglycidyl ester epoxy resin, a cycloaliphatic epoxy resin comprising a ring epoxy group, an epoxy resin containing a spiro-ring, a hydantoin epoxy resin, tris-(4-hydroxyphenyl)methane epoxy resin, or a combination comprising at least one of the foregoing; more preferably a bisphenol A epoxy resin.
Aspect 3: The curable epoxy composition according to aspect 1 or 2, wherein the hydroxyl-terminated polyphenylene ether comprises a poly(phenylene ether) copolymer derived from monomers comprising 2-methyl-6-phenylphenol and a dihydric phenol; preferably wherein the the dihydric phenol has the structure: 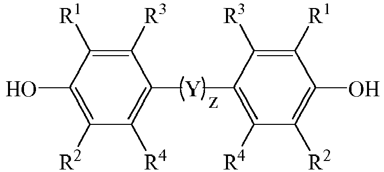 wherein each occurrence of R¹, R², R³, and R⁴ is independently hydrogen, halogen, unsubstituted or substituted C₁₋₁₂ hydrocarbyl provided that the hydrocarbyl group is not tertiary hydrocarbyl, C₁₋₁₂ hydrocarbylthio, C₁₋₁₂ hydrocarbyloxy, or C₂₋₁₂ halohydrocarbyloxy wherein at least two carbon atoms separate the halogen and oxygen atoms, z is 0 or 1, and Y is 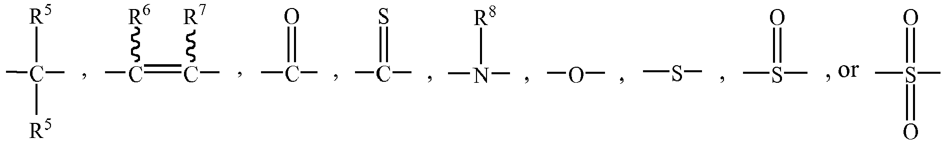 wherein each occurrence of R⁵, R⁶, R⁷, and R⁸ is independently hydrogen, C₁₋₁₂ hydrocarbyl, or C₁₋₆ hydrocarbylene wherein the two occurrences of R⁵ collectively form a C₄₋₁₂ alkylene group; more preferably wherein the hydroxyl-terminated polyphenylene ether is of the formula 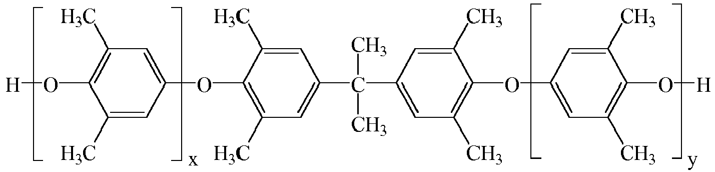 wherein x and y are independently zero to 50, provided that x + y is 4-53.
Aspect 4: The curable epoxy composition of any one or more of the preceding aspects, wherein the oligomeric aromatic organophosphate ester flame retardant is an oligomer of the formula 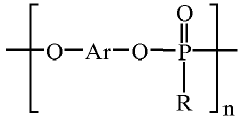 wherein Ar is a C₆₋₃₆ aromatic group, and n is 1-10; preferably wherein Ar is an aromatic group of the formula 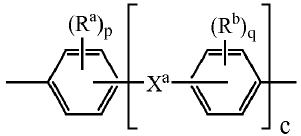 wherein R^{a} and R^{b} are each independently the same or different, and are a halogen atom or a monovalent C₁₋₆ alkyl group, p and q are each independently 0-4, c is 0-4, and X^{a} is a bridging group connecting the hydroxy-substituted aromatic groups, where the bridging group and the hydroxy substituent of each C₆ arylene group are disposed ortho, meta, or para to each other on the C₆ arylene group, more preferably wherein Ar is derived from resorcinol, hydroquinone, bisphenol A, bisphenol F, or 4,4'-biphenol.
Aspect 5: The curable epoxy composition of any one or more of the preceding aspects, excluding any phosphorus-containing flame retardant other than the oligomeric aromatic organophosphate ester flame retardant.
Aspect 6: The curable epoxy composition of any one or more of the preceding aspects, excluding a halogen-containing flame retardant.
Aspect 7: The curable epoxy resin composition according to any one or more of the preceding aspects, further comprising at least one of: an auxiliary resin comprising an epoxy resin, a cyanate ester resin, a bismaleimide resin, a polybenzoxazine resin, a vinyl resin, a phenolic resin, an alkyd resin, an unsaturated polyester resin, or a combination comprising at least one of the foregoing resins; a curing promoter comprising aliphatic and cycloaliphatic amines and amine-functional adducts with epoxy resins, Mannich bases, aromatic amines, polyamides, amidoamines, phenalkamines, dicyandiamide, polycarboxylic acid-functional polyesters, carboxylic acid anhydrides, amine-formaldehyde resins, phenol-formaldehyde resins, polysulfides, polymercaptans, or a combination comprising at least one of the foregoing curing promoter, preferably a tertiary amine, a Lewis acid, or a combination comprising at least one of the foregoing; and an additive composition, preferably wherein the additive composition comprises a particulate filler, a fibrous filler, an antioxidant, a heat stabilizer, a light stabilizer, a ultraviolet light stabilizer, a ultraviolet light-absorbing compound, a near infrared light-absorbing compound, an infrared light-absorbing compound, a plasticizer, a lubricant, a release agent, a antistatic agent, an anti-fog agent, an antimicrobial agent, a colorant, a surface effect additive, a radiation stabilizer, an anti-drip agent, a fragrance, a polymer different from the epoxy resin, or a combination comprising at least one of the foregoing, more preferably wherein additive composition comprises a particulate filler, a fibrous filler, or a combination comprising at least one of the foregoing.
Aspect 8: A circuit material prepreg comprising the curable epoxy resin composition according to any one or more of the preceding aspects.
Aspect 9: A thermoset epoxy composition comprising the cured product of the curable epoxy composition or prepreg according to any one or more of aspects 1 to 7.
Aspect 10: The thermoset epoxy composition according to aspect 9, having at least one of: a glass transition temperature of greater than or equal to 180°C, preferably greater than or equal to 190°C, more preferably greater than or equal to 200°C; a dielectric loss of less than 0.0200 measured at 1.1 Gigahertz; a char value of greater than 15 measured using a microscale combustion calorimeter; or a peak heat release rate of less than 500 Watts per gram measured using a microscale combustion calorimeter.
Aspect 11: An article comprising the thermoset epoxy composition of aspect 9 or 10.
Aspect 12: The article of aspect 11, wherein the article is in the form of in the form of a composite, a foam, a fiber, a layer, a coating, an encapsulant, an adhesive, a sealant, a component, a laminate, a prepreg, a casing, or a combination comprising at least one of the foregoing.
Aspect 13: The article of aspect 12, wherein the article is a dielectric material for a circuit component.
Aspect 14: A method for the manufacture of a thermoset epoxy composition, the method comprising: curing the epoxy composition of any one or more of aspects 1-7, preferably wherein the curing comprises heating the curable epoxy resin composition to 150-250°C in a mold.

The compositions, methods, and articles can alternatively comprise, consist of, or consist essentially of, any appropriate materials, steps, or components herein disclosed. The compositions, methods, and articles can additionally, or alternatively, be formulated so as to be devoid, or substantially free, of any materials (or species), steps, or components, that are otherwise not necessary to the achievement of the function or objectives of the compositions, methods, and articles.

All ranges disclosed herein are inclusive of the endpoints, and the endpoints are independently combinable with each other. "Combinations" is inclusive of blends, mixtures, alloys, reaction products, and the like. The terms "first," "second," and the like, do not denote any order, quantity, or importance, but rather are used to distinguish one element from another. The terms "a," "an," and "the" do not denote a limitation of quantity, and are to be construed to cover both the singular and the plural, unless otherwise indicated herein or clearly contradicted by context. "Or" means "and/or" unless clearly stated otherwise. Reference throughout the specification to "some embodiments", "an embodiment", and so forth, means that a particular element described in connection with the embodiment is included in at least one embodiment described herein, and can optionally be present in other embodiments. In addition, it is to be understood that the described elements can be combined in any suitable manner in the various embodiments.

Unless specified to the contrary herein, all test standards are the most recent standard in effect as of the filing date of this application, or, if priority is claimed, the filing date of the earliest priority application in which the test standard appears.

Unless defined otherwise, technical and scientific terms used herein have the same meaning as is commonly understood by one of skill in the art to which this application belongs. All cited patents, patent applications, and other references are incorporated herein by reference in their entirety. However, if a term in the present application contradicts or conflicts with a term in the incorporated reference, the term from the present application takes precedence over the conflicting term from the incorporated reference.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, CHO is attached through carbon of the carbonyl group.

As used herein, the term "hydrocarbyl", whether used by itself, or as a prefix, suffix, or fragment of another term, refers to a residue that contains only carbon and hydrogen. The residue can be aliphatic or aromatic, straight chain, cyclic, bicyclic, branched, saturated, or unsaturated. It can also contain combinations of aliphatic, aromatic, straight chain, cyclic, bicyclic, branched, saturated, and unsaturated hydrocarbon moieties. However, when the hydrocarbyl residue is described as substituted, it can optionally contain heteroatoms over and above the carbon and hydrogen members of the substituent residue. Thus, when specifically described as substituted, the hydrocarbyl residue can also contain one or more carbonyl groups, amino groups, hydroxyl groups, or the like, or it can contain heteroatoms within the backbone of the hydrocarbyl residue. "Alkyl" means a branched or straight chain, unsaturated aliphatic hydrocarbon group, e.g., methyl, ethyl, n-propyl, i-propyl, n-butyl, s-butyl, t-butyl, n-pentyl, s-pentyl, and n- and s-hexyl. "Alkenyl" means a straight or branched chain, monovalent hydrocarbon group having at least one carbon-carbon double bond (e.g., ethenyl (-HC=CH₂)). "Alkoxy" means an alkyl group linked via an oxygen (i.e., alkyl-O-), for example methoxy, ethoxy, and sec-butyloxy groups. "Alkylene" means a straight or branched chain, saturated, divalent aliphatic hydrocarbon group (e.g., methylene (CH₂-) or, propylene (-(CH₂)₃-)). "Cycloalkylene" means a divalent cyclic alkylene group CₙH₂ₙ₋ₓ, wherein x is the number of hydrogens replaced by cyclization(s). "Cycloalkenyl" means a monovalent group having one or more rings and one or more carbon-carbon double bonds in the ring, wherein all ring members are carbon (e.g., cyclopentyl and cyclohexyl). "Aryl" means an aromatic hydrocarbon group containing the specified number of carbon atoms, such as phenyl, tropone, indanyl, or naphthyl. "Arylene" means a divalent aryl group. "Alkylarylene" means an arylene group substituted with an alkyl group. "Arylalkylene" means an alkylene group substituted with an aryl group (e.g., benzyl). The prefix "halo" means a group or compound including one more of a fluoro, chloro, bromo, or iodo substituent. A combination of different halo groups (e.g., bromo and fluoro), or only chloro groups can be present. The prefix "hetero" means that the compound or group includes at least one ring member that is a heteroatom (e.g., 1, 2, or 3 heteroatom(s)), wherein the heteroatom(s) is each independently N, O, S, Si, or P. "Substituted" means that the compound or group is substituted with at least one (e.g., 1, 2, 3, or 4) substituents that can each independently be a C₁₋₉ alkoxy, a C₁₋₉ haloalkoxy, a nitro (-NO₂), a cyano (-N), a C₁₋₆ alkyl sulfonyl (-S(=O)₂alkyl), a C₆₋₁₂ aryl sulfonyl (-S(=O)₂-aryl), a thiol (-SH), a thiocyano (-SCN), a tosyl (CH₃C₆H₄SO₂-), a C₃₋₁₂ cycloalkyl, a C₂₋₁₂ alkenyl, a C₅₋₁₂ cycloalkenyl, a C₆₋₁₂ aryl, a C₇₋₁₃ arylalkylene, a C₄₋₁₂ heterocycloalkyl, and a C₃₋₁₂ heteroaryl instead of hydrogen, provided that the substituted atom's normal valence is not exceeded. The number of carbon atoms indicated in a group is exclusive of any substituents. For example CH₂CH₂CN is a C₂ alkyl group substituted with a nitrile.

While particular embodiments have been described, alternatives, modifications, variations, improvements, and substantial equivalents that are or may be presently unforeseen may arise to applicants or others skilled in the art. Accordingly, the appended claims as filed and as they may be amended are intended to embrace all such alternatives, modifications variations, improvements, and substantial equivalents.

## Claims

1. A curable epoxy composition, comprising:
20-93 weight percent of an epoxy resin;
2-80 weight percent of a hydroxyl-terminated polyphenylene ether; and
2-78 weight percent of an oligomeric aromatic organophosphate ester flame retardant
wherein at least 60% of the oligomeric aromatic organophosphate ester flame retardant comprises at least two hydroxy terminal groups.

2. The curable epoxy composition according to claim 1, wherein the epoxy resin composition comprises
a diglycidyl-substituted epoxy resin, a triglycidyl-substituted epoxy resin, a tetraglycidyl-substituted epoxy resin,
preferably a bisphenol A epoxy resin, a bisphenol F epoxy resin, a phenol novolak epoxy resin, a cresol novolak epoxy resin, a cycloaliphatic diglycidyl ester epoxy resin, a cycloaliphatic epoxy resin comprising a ring epoxy group, an epoxy resin containing a spiro-ring, a hydantoin epoxy resin, tris-(4-hydroxyphenyl)methane epoxy resin, or a combination comprising at least one of the foregoing;
more preferably a bisphenol A epoxy resin.

3. The curable epoxy composition according to claim 1 or claim 2, wherein the hydroxyl-terminated polyphenylene ether comprises
a poly(phenylene ether) copolymer derived from monomers comprising 2-methyl-6-phenylphenol and a dihydric phenol;
preferably wherein the the dihydric phenol has the structure: 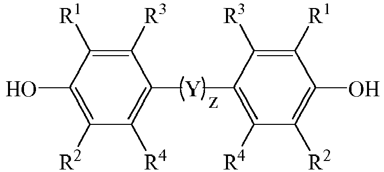 wherein each occurrence of R¹, R², R³, and R⁴ is independently hydrogen, halogen, unsubstituted or substituted C₁₋₁₂ hydrocarbyl provided that the hydrocarbyl group is not tertiary hydrocarbyl, C₁₋₁₂ hydrocarbylthio, C₁₋₁₂ hydrocarbyloxy, or C₂₋₁₂ halohydrocarbyloxy wherein at least two carbon atoms separate the halogen and oxygen atoms, z is 0 or 1, and Y is 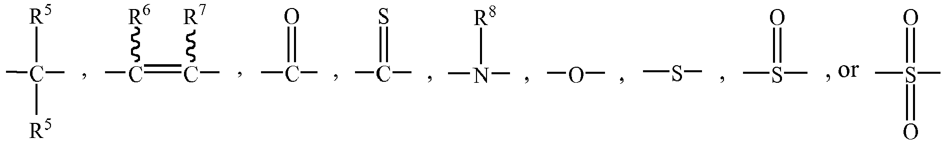 wherein each occurrence of R⁵, R⁶, R⁷, and R⁸ is independently hydrogen, C₁₋₁₂ hydrocarbyl, or C₁₋₆ hydrocarbylene wherein the two occurrences of R⁵ collectively form a C₄₋₁₂ alkylene group;
more preferably wherein the hydroxyl-terminated polyphenylene ether is of the formula 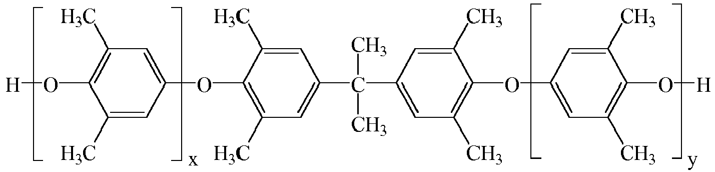 wherein x and y are independently zero to 50, provided that x + y is 4-53.

4. The curable epoxy composition of any one or more of the preceding claims, wherein the oligomeric aromatic organophosphate ester flame retardant is
an oligomer of the formula 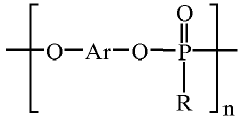 wherein Ar is a C₆₋₃₆ aromatic group, and n is 1-10;
preferably wherein Ar is an aromatic group of the formula 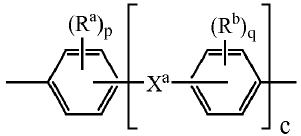 wherein R^{a} and R^{b} are each independently the same or different, and are a halogen atom or a monovalent C₁₋₆ alkyl group, p and q are each independently 0-4, c is 0-4, and X^{a} is a bridging group connecting the hydroxy-substituted aromatic groups, where the bridging group and the hydroxy substituent of each C₆ arylene group are disposed ortho, meta, or para to each other on the C₆ arylene group,
more preferably wherein Ar is derived from resorcinol, hydroquinone, bisphenol A, bisphenol F, or 4,4'-biphenol.

5. The curable epoxy composition of any one or more of the preceding claims, excluding any phosphorus-containing flame retardant other than the oligomeric aromatic organophosphate ester flame retardant.

6. The curable epoxy composition of any one or more of the preceding claims, excluding a halogen-containing flame retardant.

7. The curable epoxy resin composition according to any one or more of the preceding claims, further comprising at least one of:
an auxiliary resin comprising an epoxy resin, a cyanate ester resin, a bismaleimide resin, a polybenzoxazine resin, a vinyl resin, a phenolic resin, an alkyd resin, an unsaturated polyester resin, or a combination comprising at least one of the foregoing resins;
a curing promoter comprising aliphatic and cycloaliphatic amines and amine-functional adducts with epoxy resins, Mannich bases, aromatic amines, polyamides, amidoamines, phenalkamines, dicyandiamide, polycarboxylic acid-functional polyesters, carboxylic acid anhydrides, amine-formaldehyde resins, phenol-formaldehyde resins, polysulfides, polymercaptans, or a combination comprising at least one of the foregoing curing promoter, preferably a tertiary amine, a Lewis acid, or a combination comprising at least one of the foregoing; and
an additive composition, preferably wherein the additive composition comprises a particulate filler, a fibrous filler, an antioxidant, a heat stabilizer, a light stabilizer, a ultraviolet light stabilizer, a ultraviolet light-absorbing compound, a near infrared light-absorbing compound, an infrared light-absorbing compound, a plasticizer, a lubricant, a release agent, a antistatic agent, an anti-fog agent, an antimicrobial agent, a colorant, a surface effect additive, a radiation stabilizer, an anti-drip agent, a fragrance, a polymer different from the epoxy resin, or a combination comprising at least one of the foregoing, more preferably wherein additive composition comprises a particulate filler, a fibrous filler, or a combination comprising at least one of the foregoing.

8. A circuit material prepreg comprising the curable epoxy resin composition according to any one or more of the preceding claims.

9. A thermoset epoxy composition comprising the cured product of the curable epoxy composition or prepreg according to any one or more of claims 1 to 7.

10. The thermoset epoxy composition according to claim 9, having at least one of:
a glass transition temperature of greater than or equal to 180°C, preferably greater than or equal to 190°C, more preferably greater than or equal to 200°C;
a dielectric loss of less than 0.0200 measured at 1.1 Gigahertz;
a char value of greater than 15 measured using a microscale combustion calorimeter; or
a peak heat release rate of less than 500 Watts per gram measured using a microscale combustion calorimeter.

11. An article comprising the thermoset epoxy composition of claim 9 or claim 10.

12. The article of claim 11, wherein the article is in the form of in the form of a composite, a foam, a fiber, a layer, a coating, an encapsulant, an adhesive, a sealant, a component, a laminate, a prepreg, a casing, or a combination comprising at least one of the foregoing.

13. The article of claim 12, wherein the article is a dielectric material for a circuit component.

14. A method for the manufacture of a thermoset epoxy composition, the method comprising:
curing the epoxy composition of any one or more of claims 1-7
preferably wherein the curing comprises heating the curable epoxy resin composition to 150-250°C in a mold.
